# FASCICULE DE BREVET EUROPEEN

(11) **EP 3 913 687 B1**
(45) Date de publication et mention de la délivrance du brevet: **17.12.2025**
(21) Numéro de dépôt: 21174012.1
(22) Date de dépôt: 17.05.2021
(51) Int. Cl.: H10D 8/60, H10D 30/47, H10D 62/10, H10D 62/824, H10D 64/00, H10D 64/27, H10D 62/85

(54) **COMPOSANT ÉLECTRONIQUE À HÉTÉROJONCTION COMPRENANT UNE PLAQUE DE CHAMP ET UNE RÉGION FLOTTANTE DOPÉE P**
ELEKTRONISCHES BAUELEMENT MIT HETEROÜBERGANG MIT EINER FELDPLATTE UND EINEM P-DOTIERTEN SCHWEBENDEN BEREICH
ELECTRONIC COMPONENT WITH HETEROJUNCTION COMPRISING A FIELD PLATE AND A P-DOPED FLOATING REGION

(30) Priorité: 19.05.2020 FR 2005011
(43) Date de publication de la demande: 24.11.2021
(73) Titulaire: Commissariat à l'Energie Atomique et aux Energies Alternatives, 75015 Paris (FR)
(72) Inventeur: RIGAUD-MINET, Florian, 38054 GRENOBLE CEDEX 09 (FR)
(74) Mandataire: Cabinet Camus Lebkiri

(56) Documents cités:
- JP-A- 2012 028 409
- US-A1- 2015 270 355
- US-A1- 2015 270 379
- SEUNG-CHUL LEE ET AL: "High Breakdown Voltage GaN Schottky Barrier Diode employing Floating Metal Rings on AlGaN/GaN Hetero-junction", POWER SEMICONDUCTOR DEVICES AND ICS, 2005. PROCEEDINGS. ISPSD '05. THE 17TH INTERNATIONAL SYMPOSIUM ON SANTA BARBARA, CA, USA MAY 23-26, 2005, PISCATAWAY, NJ, USA,IEEE, 23 May 2005 (2005-05-23), pages 247 - 250, XP010820737, ISBN: 978-0-7803-8890-1, DOI: 10.1109/ISPSD.2005.1487997

## Description

### DOMAINE TECHNIQUE DE L'INVENTION

La présente invention est relative aux composants électroniques de puissance à base d'hétérojonction, tels que les transistors à haute mobilité d'électrons (ou HEMT, pour « High Electron Mobility Transistor » en anglais) et les diodes latérales Schottky à base de nitrure de galium (GaN).

### ARRIERE-PLAN TECHNOLOGIQUE DE L'INVENTION

Une hétérojonction est formée par la jonction de deux matériaux semi-conducteurs ayant des largeurs de bande interdite différentes. Par exemple, une hétérojonction du type AlGaN/GaN comprend une couche de nitrure de galium (GaN) surmontée d'une couche de nitrure d'aluminium-gallium (AlGaN). Un gaz d'électrons bidimensionnel (ou 2DEG, pour « 2-Dimensional Electron Gaz » en anglais) se forme à l'interface entre la couche d'AlGaN et la couche de GaN, du fait d'une polarisation spontanée et d'une polarisation piézoélectrique. Ce gaz d'électrons bidimensionnel sert de canal de conduction au sein des composants électroniques à hétérojonction, tels que les transistors HEMT et les diodes latérales Schottky.

Les composants électroniques à hétérojonction supportent des densités de courant élevées à l'état passant, en raison de la forte densité de porteurs de charge (électrons) et de la grande mobilité de ces porteurs dans le gaz d'électrons bidimensionnel. Pour certaines applications telles que la commutation à haute tension, il est important que ces composants électroniques présentent en outre une bonne tenue en tension dans l'état bloqué, autrement dit une tension de claquage élevée.

Le document [« RESURF AlGaN/GaN HEMT for high voltage power switching », IEEE Electron Device Letters, Vol. 22, No 8, p. 373-375, 2001] décrit un transistor HEMT AlGaN/GaN ayant une tension de claquage élevée, supérieure à 1 kV.

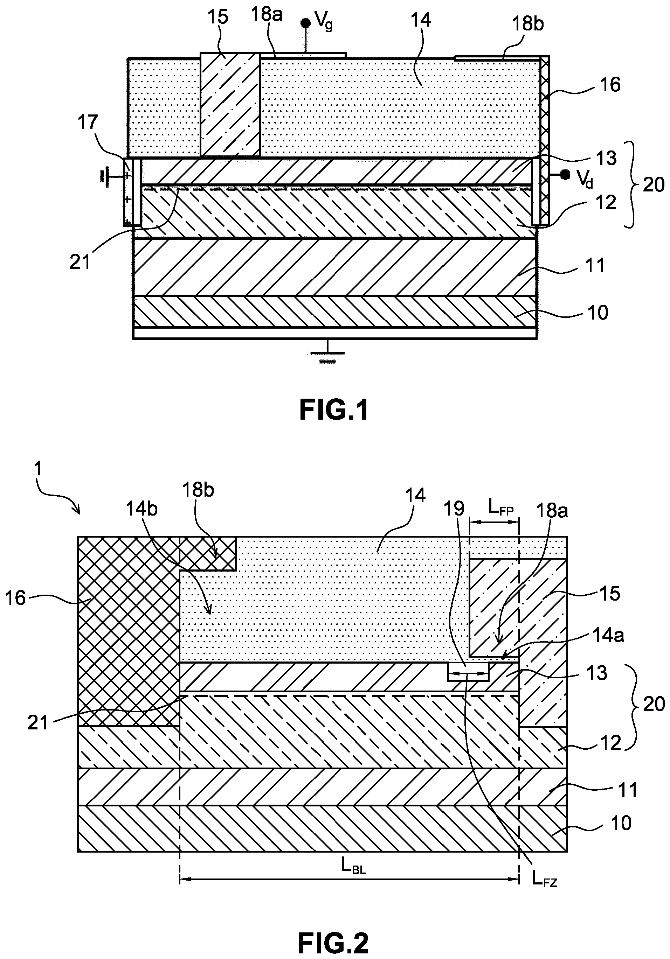

En référence à la figure 1, ce transistor comprend un substrat 10, une couche tampon 11 en GaN dopé p (p-GaN) disposée sur le substrat 10, une couche de canal 12 en GaN dopé n (n-GaN) disposée sur la couche tampon 11, une couche barrière 13 en AlGaN dopé n (n-AlGaN) disposée sur la couche de canal 12 et une couche de passivation 14 disposée sur la couche barrière 13. La couche de canal 12 en n-GaN et la couche barrière 13 en n-AlGaN forment une hétérojonction 20. Un gaz d'électrons bidimensionnel 21 est intrinsèquement formé à l'interface entre la couche de canal 12 et la couche barrière 13. Ce gaz d'électrons bidimensionnel 21 est illustré en traits pointillés sur la figure 1.

Le transistor comprend en outre une électrode de grille 15, s'étendant à travers la couche de passivation 14 pour être en contact avec la couche barrière 13, des électrodes de drain et de source 16-17 reliées entre elles par le gaz d'électrons bidimensionnel 21 et deux plaques de champs 18a-18b disposées sur la couche de passivation 14, formant respectivement des extensions de l'électrode de grille 15 et de l'électrode de drain 16.

La couche tampon 11 en p-GaN et la couche de canal 12 en n-GaN forment ensemble une jonction PN sous l'hétérojonction, qui améliore le confinement du gaz d'électrons bidimensionnel en créant une barrière de potentiel enterrée (« back-barrier » en anglais).

La jonction PN et les plaques de champ 18a-18b redistribuent le champ électrique de façon plus uniforme dans le composant, ce qui a pour conséquence d'augmenter la tension de claquage du transistor (c'est-à-dire la tension maximale admissible entre le drain et la source à l'état bloqué).

Cependant, la jonction PN a également pour effet de dépléter partiellement le gaz d'électrons bidimensionnel 21, ce qui entraîne une augmentation de la résistance à l'état passant du composant, d'environ 14 % par rapport à une structure dépourvue de jonction PN.

Le document US2015/270355 décrit un autre transistor à hétérojonction AlGaN/GaN, comprenant une couche de canal en GaN, une couche barrière en AlGaN disposée sur la couche de canal, une électrode de source, une électrode de drain, une électrode de grille et une plaque de champ formant une extension de l'électrode de source. Le transistor comprend en outre une couche flottante en AlGaN dopé p disposée sur la couche barrière entre l'électrode de grille et l'électrode de drain, à l'aplomb d'un flanc de la plaque de champ. Cette couche flottante en AlGaN dopé p, appelée couche RESURF (pour « Reduced Surface Field » en anglais), diminue le champ électrique dans la couche de passivation séparant la plaque de champ et l'électrode de grille, en particulier les pics de champ à l'extrémité de la plaque de champ et à l'extrémité de l'électrode de grille. Cet effet de réduction du champ électrique reste cependant limité à la couche de passivation.

### RESUME DE L'INVENTION

L'invention a pour but d'augmenter la tension de claquage d'un composant électronique à hétérojonction tout en limitant l'augmentation de sa résistance électrique à l'état passant.

Selon l'invention, on tend vers cet objectif en prévoyant un composant électronique à hétérojonction comprenant :
- un substrat ;
- une hétérojonction comprenant une couche de canal disposée sur le substrat et une couche barrière disposée sur la couche de canal ;
- une couche de passivation disposée sur la couche barrière ;
- une plaque de champ séparée de la couche barrière par une portion de la couche de passivation ; et
- une région flottante en un matériau semi-conducteur dopé de type p, située dans la couche barrière à l'aplomb d'un flanc de la plaque de champ, la région flottante ayant une épaisseur inférieure à celle de la couche barrière.

La région flottante dopée p située dans la couche barrière réduit le champ électrique dans la couche de passivation mais également dans la couche barrière, ce qui résulte en une augmentation de la tension de claquage du composant. En outre, cette région flottante confine le gaz d'électrons bidimensionnel de l'hétérojonction de façon moins importante qu'une couche de confinement disposée sous la couche de canal. L'augmentation de la tension de claquage ne se fait donc pas au détriment d'une dégradation significative des autres caractéristiques électriques du composant, en particulier de sa résistance à l'état passant.

Dans le transistor du document US2015/270355, la région flottante est disposée sur la couche barrière, et non à l'intérieur des limites de la couche barrière. Le champ électrique (latéral) dans le couche barrière n'est pas diminué mais reporté et concentré à l'extrémité distale de la région flottante. Il en résulte un risque de claquage du composant en ce point de report. Par ailleurs, le champ électrique est également augmenté dans le gaz d'électrons bidimensionnel (formant une partie du canal de conduction du transistor), ce qui peut entraîner l'apparition de porteurs chauds lors de la commutation du transistor.

De préférence, le composant comprend en outre une première électrode et une deuxième électrode séparée de la première électrode par une partie au moins de la couche de passivation.

Dans un mode de réalisation, le composant est de type diode, la première électrode est une anode et la deuxième électrode est une cathode.

Dans un mode de réalisation, le composant est de type transistor, la première électrode est une électrode de grille et la deuxième électrode est une électrode de drain.

Dans un mode de réalisation compatible avec les deux précédents, le composant comprend une pluralité de plaques de champs et une pluralité de régions flottantes en matériau semi-conducteur dopé de type p, chaque région flottante étant située dans la couche barrière à l'aplomb d'un flanc d'une des plaques de champ.

Outre les caractéristiques qui viennent d'être évoquées dans les paragraphes précédents, le composant selon l'invention peut présenter une ou plusieurs caractéristiques complémentaires parmi les suivantes, considérées individuellement ou selon toutes les combinaisons techniquement possibles :
- la région flottante présente une concentration en impuretés dopantes de type p comprise entre 1.10¹⁸ cm⁻³ et 2.10¹⁹ cm⁻³ ;
- la région flottante est centrée par rapport au flanc de la plaque de champ ;
- la région flottante présente une largeur inférieure à deux fois la largeur de la plaque de champ ;
- la plaque de champ forme une extension de la première électrode ;
- la couche barrière est constituée du matériau semi-conducteur non intentionnellement dopé ; et
- la région flottante est en contact direct avec la couche de passivation.

L'invention et ses différentes applications seront mieux comprises à la lecture de la description qui suit et à l'examen des figures qui l'accompagnent.

### BREVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :
[Fig. 1], précédemment décrite, représente schématiquement un transistor à hétérojonction selon l'art antérieur ;
[Fig. 2] représente un premier mode de réalisation d'un composant électronique à hétérojonction selon l'invention ;
[Fig. 3] montre la caractéristique I-V en direct d'une diode latérale Schottky munie d'une région flottante dopée p, selon un aspect de l'invention, et la caractéristique I-V en direct d'une diode latérale Schottky dépourvue de région flottante dopée p ;
[Fig. 4] montre la caractéristique I-V en inverse d'une diode latérale Schottky munie d'une région flottante dopée p, selon un aspect de l'invention, et la caractéristique I-V en inverse d'une diode latérale Schottky dépourvue de région flottante dopée p ;
[Fig. 5] représente un deuxième mode de réalisation d'un composant électronique à hétérojonction selon l'invention ;
[Fig. 6] représente un troisième mode de réalisation d'un composant électronique à hétérojonction selon l'invention ;
[Fig. 7] représente le champ électrique en valeur absolue dans la couche barrière d'un exemple de composant selon l'invention et, à titre de comparaison, celui d'un transistor selon le document US2015/270355 et celui d'un transistor dépourvu de région flottante ; et
[Fig. 8] représente le champ électrique en valeur absolue sous l'hétérojonction d'un exemple de composant selon l'invention et, à titre de comparaison, celui d'un transistor selon le document US2015/270355 et celui d'un transistor dépourvu de région flottante.

Pour plus de clarté, les éléments identiques ou similaires sont repérés par des signes de référence identiques sur l'ensemble des figures.

### DESCRIPTION DETAILLEE

La figure 2 représente en vue de coupe schématique un premier mode de réalisation d'un composant électronique à hétérojonction 1. Ce type de composant trouve des applications avantageuses en électronique de puissance, par exemple en tant que commutateur de puissance. Le composant 1 peut ainsi commuter de manière réversible entre un premier état appelé « état passant » (ou « état ON ») et un deuxième état appelé « état bloqué » (ou « état OFF »).

Le composant 1 comprend un substrat 10 et une hétérojonction 20 disposée sur le substrat 10. L'hétérojonction 20 comprend une première couche semi-conductrice 12, appelée communément « couche de canal » et disposée sur le substrat 10, et une deuxième couche semi-conductrice 13, appelée communément « couche barrière » et disposée sur la couche de canal 12. Un gaz d'électrons bidimensionnel 21 (ou 2DEG, pour « 2-Dimensional Electron Gaz » en anglais) est formé intrinsèquement (par hétérojonction) à l'interface entre la couche de canal 12 et la couche barrière 13. Sur la figure 2, il est symbolisé par des traits en pointillés dans la couche de canal 16 le long de l'interface entre la couche de canal 16 et la couche barrière 17.

Le substrat 10 est par exemple en silicium (Si), en carbure de silicium (SiC), en nitrure de galium (GaN) ou en saphir (Al₂O₃). La couche de canal 12 et la couche barrière 13 sont formées de matériaux semi-conducteurs ayant des largeurs de bande interdite différentes. La couche de canal 12 et la couche barrière 13 sont de préférence des couches en matériau semi-conducteur III-V, par exemple à base de GaN (en GaN ou alliage de GaN comme AlGaN, InGaN...).

L'hétérojonction 20 est par exemple de type GaN/AlGaN. La couche de canal 12 est alors constituée de nitrure de galium, de préférence non intentionnellement dopé (UID GaN), tandis que la couche barrière 13 est constituée de nitrure d'aluminium-galium, de préférence non intentionnellement dopé (UID AlGaN). Un matériau semi-conducteur est considéré comme non intentionnellement dopé lorsque ses concentrations en dopants de type donneur et de type accepteur sont inférieures à 10¹⁶ cm⁻³ (N_{A}<10¹⁶ cm⁻³ et N_{D}<10¹⁶ cm⁻³). De préférence, la couche de canal 12 présente une épaisseur comprise entre 20 nm et 500 nm, tandis que la couche barrière 13 présente une épaisseur comprise entre 2 nm et 30 nm. L'épaisseur d'une couche est mesurée dans une direction perpendiculaire au substrat 10.

Alternativement, la couche de canal 12 et la couche barrière 13 peuvent être respectivement en GaAs et AlₓGa₁₋ₓAs (x<0,25), ou en Ga_{y}In_{1-y}As (y-0,8) et AlₓGa₁₋ₓAs (x<0,25).

L'hétérojonction 20 peut également comprendre une couche intermédiaire (non illustrée sur la figure), interposée entre la couche de canal 12 et la couche barrière 13, pour accroître la densité et la mobilité des électrons dans le gaz d'électrons bidimensionnel 21. Une telle couche intermédiaire est typiquement extrêmement fine (par exemple de 1 nm d'épaisseur) et peut être constituée de nitrure d'aluminium (AIN), ce matériau étant particulièrement adapté à l'interface entre une couche de canal 12 en GaN et une couche barrière 13 en AlGaN.

Toujours en référence à la figure 2, le composant 1 comprend avantageusement une couche tampon 11, semi-isolante, disposée entre le substrat 10 et la couche de canal 12. Cette couche tampon 11 limite les courants de fuite latéraux et verticaux dans le composant 1 et améliore sa tenue en tension (latérale) dans l'état bloqué, autrement dit sa capacité à supporter des tensions inverses élevées. La couche tampon 11 comprend de préférence un matériau semi-conducteur, tel que le GaN ou l'AlGaN. Ce matériau semi-conducteur peut être dopé avec des impuretés, telles que des atomes de carbone. La couche tampon 11 peut notamment être formée par une seule couche de GaN:C ou par un bicouche GaN:C/AlₓGa₁₋ₓN, avec x compris entre 4 % et 8 % environ. L'épaisseur de la couche tampon 11 est choisie en fonction de la tension de claquage souhaitée pour le composant 1. Elle est par exemple comprise entre 1 µm et 15 µm.

Dans le cas d'un substrat 10 en un matériau autre que le GaN (ex. Si, SiC ou saphir), le composant 1 peut comprendre en outre une couche de transition (non représentée sur les figures) disposée entre le substrat 10 et la couche de canal 12, et plus particulièrement entre le substrat 10 et la couche tampon 11. Cette couche de transition permet d'adapter le paramètre de maille cristalline et de gérer les contraintes mécaniques entre le substrat 10 et les couches de l'hétérojonction 20. Elle peut comprendre une sous-couche de nucléation (par exemple une couche d'AIN de 100 nm d'épaisseur), en contact avec le substrat 10, et plusieurs sous-couches d'adaptation empilées sur la sous-couche de nucléation. Les sous-couches d'adaptation comprennent par exemple de l'AlGaN dont le taux d'aluminium varie d'une couche à l'autre (par exemple plusieurs couches d'AlGaN avec une fraction molaire d'AIN qui décroit avec l'éloignement par rapport au substrat 10, ou un super-réseau comprenant plusieurs bicouches AlₓGa₁₋ₓN/GaN).

Le composant 1 comprend également une couche de passivation 14 disposée sur la couche barrière 13, une première électrode 15 et une deuxième électrode 16 séparée (latéralement) de la première électrode 15 par une partie au moins de la couche de passivation 14. La première électrode 15 et la deuxième électrode 16 reposent par exemple sur une portion inférieure de la couche de canal 12. Une portion supérieure de la couche de canal 12, la couche barrière 13 et une portion au moins de la couche de passivation 14 s'étendent entre la première électrode 15 et la deuxième électrode 16.

La couche de passivation 14 peut être constituée d'un seul matériau électriquement isolant, par exemple de dioxyde de silicium (SiO₂), nitrure de silicium (Si₃N₄), nitrure d'aluminium (AIN) ou alumine (Al₂O₃). Alternativement, la couche de passivation peut comporter plusieurs sous-couches empilées et formées de matériaux isolants différents, typiquement une alternance de sous-couche en oxyde (ex. SiO₂) et en nitrure (ex. SiN). Ces différentes sous-couches servent de support à la réalisation d'une ou plusieurs plaques de champ, décrites ci-après.

Chacune des première et deuxième électrodes 15-16 peut être constituée d'un matériau métallique, de préférence choisi parmi l'aluminium (AI), le cuivre (Cu), l'or (Au), le titane (Ti), le nitrure de titane (TiN) et le nickel (Ni), ou de plusieurs matériaux métalliques empilés. Le(s) matériau(x) utilisé(s) pour former la première électrode 15 peut (peuvent) être différent(s) du (des) matériau(x) utilisé(s) pour former la deuxième électrode 16. Par exemple, la première électrode 15 est constituée de nickel (composé métallique de barrière, recuit à basse température) et la deuxième électrode 16 est constituée d'un empilement Al/Ti.

Dans ce premier mode de réalisation, le composant 1 est une diode latérale Schottky. La première électrode 15 est une anode, en contact Schottky avec le gaz d'électrons bidimensionnel 21, et la deuxième électrode 16 est une cathode, en contact ohmique avec le gaz d'électrons bidimensionnel 21. L'anode et la cathode sont situées à des extrémités opposées du gaz d'électrons bidimensionnel 21. Elles sont reliées par le gaz d'électrons bidimensionnel 21.

Le composant 1 comprend en outre une première plaque de champ 18a, associée à la première électrode 15 et séparée de la couche barrière 13 par une première portion 14a (typiquement une sous-couche) de la couche de passivation 14. La première plaque de champ 18a peut former une extension de la première électrode 15, qui s'étend de préférence parallèlement à la couche barrière 13 en direction de la deuxième électrode 16. En d'autres termes, elle peut être formée par une portion en saillie de la première électrode 15. La première plaque de champ 18a peut être formée du (ou des) même(s) matériau(x) métallique(s) que la première électrode 15 ou d'un (ou plusieurs) matériau(x) métallique(s) différent(s). La première portion 14a de la couche de passivation 14 présente de préférence une épaisseur constante.

De façon optionnelle, le composant 1 comprend une deuxième plaque de champ 18b, associée à la deuxième électrode 16 et séparée de la couche barrière 13 par une deuxième portion 14b de la couche de passivation 14 (de préférence d'épaisseur constante). La deuxième plaque de champ 18b peut former une extension de la deuxième électrode 16, qui s'étend de préférence parallèlement à la couche barrière 13 en direction de la première électrode 15.

Les plaques de champ 18a-18b réduisent les pics de champ électrique dus aux discontinuités abruptes entre les différents matériaux du composant 1. Elles répartissent le champ électrique de manière plus uniforme au sein du composant 1 et améliore sa tenue en tension.

Enfin, le composant 1 comprend une région flottante 19 située dans la couche barrière 13 à l'aplomb d'un flanc de la première plaque de champ 18a. Une région flottante désigne une région soumise à aucune polarisation électrique extérieure (c.-à-d. aucun potentiel électrique n'est appliqué sur cette région), contrairement aux première et deuxième électrodes 15-16. Ainsi, la région flottante 19 est isolée électriquement des électrodes du composant 1. Une première portion de la couche barrière 13 sépare la région flottante 19 de la première électrode 15 et une deuxième portion de la couche barrière 13 sépare la région flottante 19 de la deuxième électrode 16.

Le flanc de la première plaque de champ 18a, sous lequel se situe la région flottante 19 est celui le plus éloigné de la première électrode 15. En d'autres termes, la région flottante 19 est située à l'aplomb d'une extrémité distale de la première plaque de champ 18a (par rapport à la première électrode 15).

La région flottante 19 est constituée d'un matériau semi-conducteur dopé de type p. Ce matériau semi-conducteur est avantageusement le même que celui formant la couche barrière 13, dans cet exemple l'AlGaN. Ainsi, la fabrication du composant 1 est simplifiée. La région flottante 19 peut notamment être formée en dopant avec des impuretés dopantes de type p (par exemple des ions magnésium) une portion de la couche barrière 13.

La région flottante 19 présente une épaisseur inférieure à celle de la couche barrière 13, afin de ne pas interrompre le gaz d'électrons bidimensionnel 21 entre la première électrode 15 et la deuxième électrode 16. La région flottante 19 est avantageusement en contact direct avec la couche de passivation 14, comme cela est représenté sur la figure 2. La région flottante 19 peut ainsi être réalisée plus facilement et à moindre coût.

La région flottante 19 présente dans un plan parallèle au substrat 10 au moins une dimension inférieure à celle de la couche barrière 13. Autrement dit, la région flottante 19 n'occupe qu'une partie de la couche barrière 13 dans un plan parallèle au substrat 10. Plus précisément, dans le plan de coupe de la figure 2, la région flottante 19 présente une largeur L_{FZ} inférieure à la largeur L_{BL} de la couche barrière 13, soit la distance entre les première et deuxième électrodes 15-16.

La région flottante 19 réduit (à une tension inverse donnée) le champ électrique dans la portion de la couche de passivation 14 située au-dessus de la région flottante 19 et dans la portion de la couche barrière 13 séparant la région flottante 19 de la couche de canal 12, et plus particulièrement à la verticale du flanc de la première plaque de champ 18a. Ces deux zones du composant sont habituellement limitantes en termes de tenue en tension, car le champ électrique y est très fort.

La réduction du champ électrique dans la couche de passivation 14 et dans la couche barrière 13 est le résultat d'une plus grande ionisation des impuretés dopantes de type donneur (grâce aux porteurs de charge libres - des trous - apportés par la région flottante 19) à l'interface entre la couche de passivation 14 et la couche barrière 13. L'augmentation de la densité de donneurs ionisés à l'interface abaisse localement la bande de conduction dans la région flottante 19 et dans la couche de passivation 14, ce qui compense le relèvement de la bande de conduction due à la présence de la région dopée p.

En réduisant ainsi localement le champ électrique dans le composant, celui-ci peut supporter une tension inverse plus élevée. La tension de claquage du composant est donc augmentée.

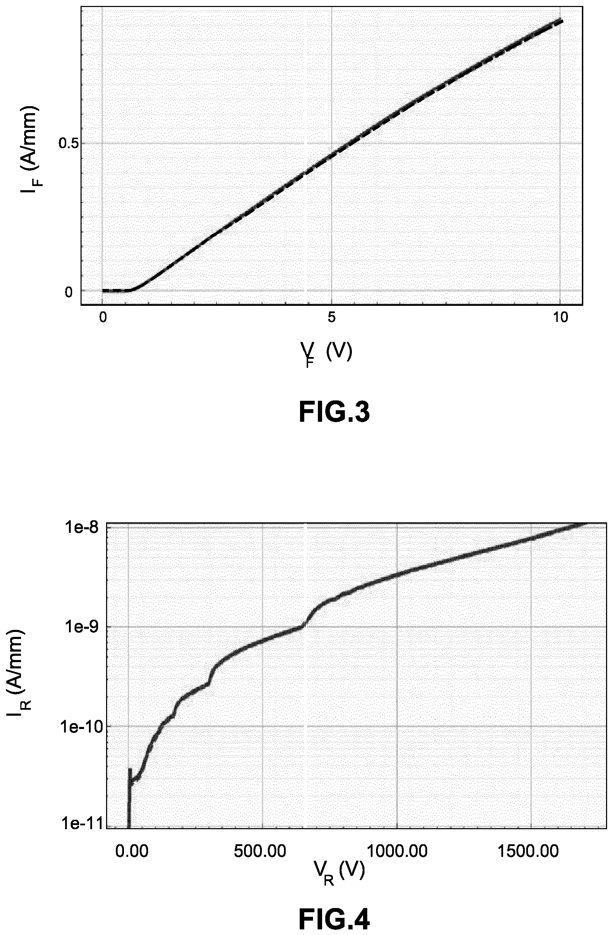

La figure 3 représente la densité de courant en direct I_{F} d'une diode latérale Schottky selon la figure 2 en fonction de la tension de polarisation directe V_{F} et, à titre de comparaison, la densité de courant en direct I_{F} d'une diode latérale Schottky dépourvue de région flottante 19 dans la couche barrière 13.

Les deux courbes sont presque superposées. Cela signifie que la région flottante 19 n'a quasiment aucun impact sur les performances en direct de la diode, en particulier sur la tension de seuil et la résistance à l'état passant.

La figure 4 représente la densité de courant en inverse I_{R} en fonction de la tension de polarisation inverse V_{R} pour ces deux mêmes diodes latérales Schottky. A nouveau, les courbes se superposent. La région flottante 19 n'a donc pas d'influence sur le courant de fuite en inverse de la diode. On notera que la figure 4 ne représente pas la tension de claquage de la diode.

D'autres caractérisations (C-V notamment) ont montré que la capacité du composant n'était pas modifiée de façon substantielle par l'insertion de la région flottante 19 dans la couche barrière 13.

Ainsi, comparativement à une couche de confinement dopée p disposée sous la couche de canal 12 et qui s'étend sur toute la longueur du gaz d'électrons bidimensionnel 21, la région flottante 19 disposée dans la couche barrière 13 a un impact négatif limité sur les performances du composant 1, et notamment sa résistance à l'état passant.

La région flottante 19 est avantageusement centrée (c.-à-d. disposée de façon symétrique) par rapport au flanc de la première plaque de champ 18a, afin de réduire au maximum le champ électrique dans la couche barrière 13 et la couche de passivation 14. Elle peut aussi être légèrement décalée, vers la première électrode 15 ou la deuxième électrode 16, tant qu'elle est traversée par la projection verticale du flanc de la première plaque de champ 18a.

La largeur L_{FZ} de la région flottante 19 (mesurée parallèlement au substrat 10 dans le plan de coupe de la figure 2) est de préférence inférieure à deux fois la largeur L_{FP} de la première plaque de champ 18a. Ainsi, lorsque la région flottante 19 est centrée par rapport au flanc (extérieur) de la première plaque de champ 18a, elle n'entre pas en contact avec la première électrode 15.

La concentration en impuretés dopantes de type p (activées) de la région flottante 19 est avantageusement comprise entre 1.10¹⁸ cm⁻³ et 2.10¹⁹ cm⁻³, afin d'obtenir une réduction significative du champ électrique sans diminuer de façon trop importante la densité d'électrons dans le gaz d'électrons bidimensionnel 21. Selon la concentration en impuretés dopantes de la région flottante 19, l'épaisseur de la région flottante 19 peut être comprise entre 10 % et 90 % de l'épaisseur de couche barrière 13.

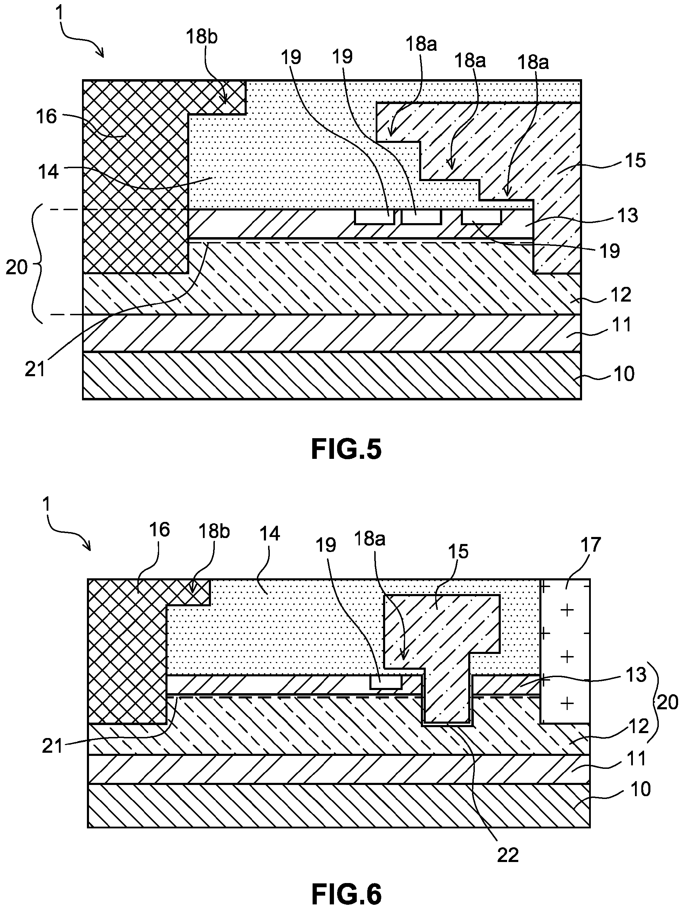

Dans un deuxième mode de réalisation illustré par la figure 5, le composant 1 comprend plusieurs plaques de champ 18a associées à la première électrode 15 et plusieurs régions flottantes dopées p 19, telles que décrites précédemment.

Les plaques de champ 18a forment de préférence des extensions de la première électrode 15 (ou des avancées de la première électrode 15 dans la couche de passivation 14). Elles peuvent être séparées deux-à-deux par une portion (typiquement une sous-couche) de la couche de passivation 14 ou, comme cela est représenté sur la figure 5, en contact les unes aux autres, par exemple en forme de marches d'escalier.

Chacune des régions flottantes 19 est située dans la couche barrière 13 à la verticale d'au moins un flanc de plaque de champ (formant pour certains une transition entre deux plaques de champ successives), et de préférence à la verticale d'un flanc d'une seule plaque de champ. Chaque région flottante 19 réduit le champ électrique localement, c'est-à-dire dans les portions de la couche de passivation 14 et de la couche barrière 13 disposées en regard. Une plaque de champ 19 disposée sous un flanc d'une (seule) plaque de champ 18a n'a pas d'effet sur le champ électrique sous le flanc de la plaque de champ 18a adjacente.

Prévoir plusieurs régions flottantes 19 distinctes et associées chacune à une seule plaque de champ 18a, plutôt qu'une seule région flottante s'étendant le long de plusieurs plaques de champ, réduit de façon importante le champ électrique tout en limitant le confinement du gaz d'électrons bidimensionnel 21.

De façon avantageuse, à chaque plaque de champ 18a est associée une seule région flottante 19.

Trois plaques de champ 18a et trois régions flottantes 19 ont été représentés à titre d'exemple sur la figure 5. D'une manière plus générale, le composant 1 peut comporter N plaques de champ 18a associées à la première électrode 15 et M régions flottantes 19, N et M étant des entiers naturels supérieurs ou égaux à 2 et M étant inférieur ou égal à N.

Dans un troisième mode de réalisation illustré par la figure 6, le composant 1 est un transistor à hétérojonction, aussi appelé transistor à haute mobilité d'électrons (ou HEMT, pour « High Electron Mobility Transistor » en anglais). La première électrode est une électrode de grille, isolée de l'hétérojonction 20 par une couche diélectrique 22, typiquement en un oxyde appelé « oxyde de grille », et la deuxième électrode 16 est une électrode de drain. Outre la première électrode 15, la deuxième électrode 16 et tous les autres éléments décrits précédemment en relation avec la figure 2, le transistor comprend une troisième électrode 17 formant une électrode de source.

L'électrode de grille 15 du transistor est disposée entre les électrodes de drain et de source 16-17. Elle peut diviser le gaz d'électrons bidimensionnel 21 en deux en s'étendant à travers la couche barrière 13 et une partie de la couche de canal 12, comme illustré sur la figure 6, ou au contraire le laisser entier et s'arrêter sur la couche barrière 13.

L'électrode de drain 16 et l'électrode de source 17 sont situées à des extrémités opposées du gaz d'électrons bidimensionnel 21. Lorsque le transistor est dans l'état passant, elles sont reliées électriquement par le gaz d'électrons bidimensionnel 21 et un canal de conduction, formé par une couche d'inversion qui accumule les électrons le long de la couche d'oxyde de grille.

Le transistor à hétérojonction peut comprend une seule plaque de champ 18a côté grille et une seule région flottante 19, comme décrit en relation avec la figure 2, ou plusieurs (N) plaques de champ 18a côté grille et plusieurs (M≤N) régions flottantes 19, comme décrit en relation avec la figure 5. Les plaques de champ 18a et les régions flottantes 19 sont situées entre l'électrode de grille 15 et l'électrode de drain 16 (là où le champ électrique est le plus fort).

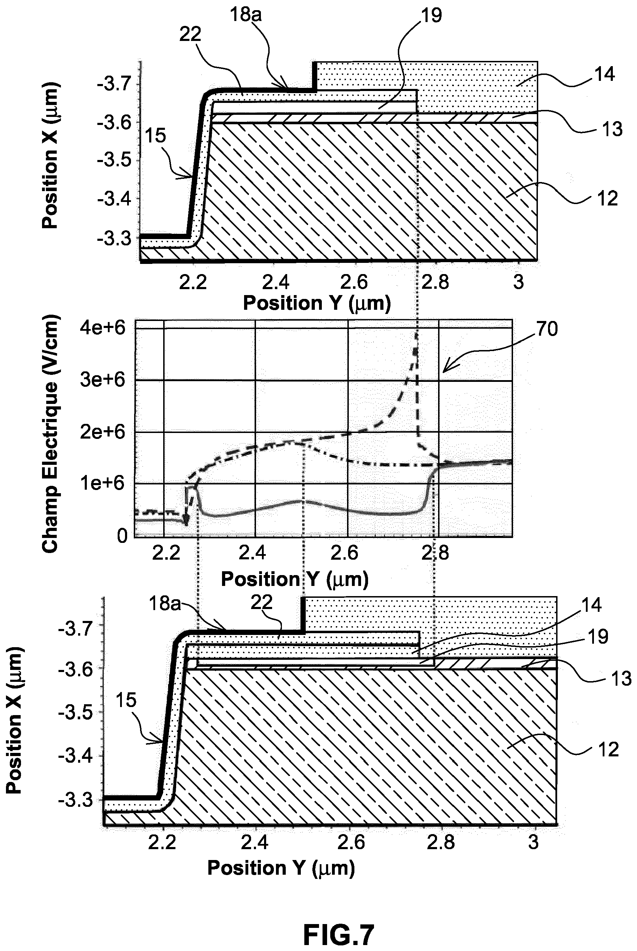

La figure 7 représente le champ électrique en valeur absolue dans la couche barrière 13 d'un transistor à hétérojonction selon un exemple de réalisation de l'invention (en trait plein) et, à titre de comparaison, celui d'un transistor selon le document US2015/270355 (en trait pointillés) et celui d'un transistor dépourvu de région flottante (en trait mixte). Le transistor selon l'invention (représenté en bas sur la figure) comprend ici une plaque de champ 18a en extension de la grille 15 et une seule région flottante 19. Le champ électrique est simulé à 1 nm sous l'interface entre la couche barrière 13 et la couche de passivation 14 (ou entre la couche barrière 13 et la région flottante 19 dans le cas du document US2015/270355).

La figure 7 montre que, lorsque la région flottante 19 est introduite dans la couche barrière 13, le champ électrique est réduit dans la couche barrière 13, en particulier sous le flanc de la plaque de champ 18a (courbe en trait plein vs. courbe en trait mixte). Lorsque la région flottante 19 est située sur la couche barrière 13 (document US2015/270355), le champ électrique est au contraire inchangé sous le flanc de la plaque de champ 18a. Pire, il augmente fortement à l'extrémité distale de la région flottante 19, formant un pic de champ 70 (courbe en traits pointillés).

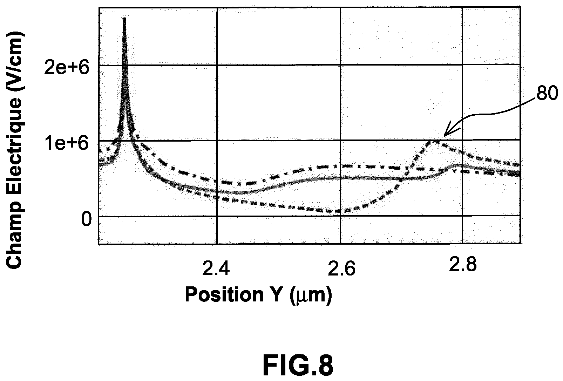

La figure 8 représente pour ces mêmes transistors le champ électrique en valeur absolue à 1 nm en dessous de l'hétérojonction, autrement dit dans la région dite de « canal » où se forme le gaz d'électrons bidimensionnel (cependant, à l'état bloqué, le gaz d'électrons bidimensionnel est déplété). Cette figure montre qu'un autre pic de champ 80 apparaît dans la région de canal, à l'aplomb de l'extrémité distale de la région flottante 19, lorsque cette dernière est située sur la couche barrière 13. Un champ élevé dans la région de canal peut créer des porteurs chauds lors de la commutation du transistor et entraîner sa destruction.

La fabrication du composant électronique à hétérojonction 1 peut comporter les étapes suivantes :
- former successivement sur le substrat 10, par exemple par épitaxie, la couche de nucléation, les couches d'adaptation et/ou la couche tampon 11 (le cas échéant), la couche de canal 12 et la couche barrière 13 ;
- former la région flottante dopée p 19 dans la couche barrière 13 ;
- former la couche de passivation 14 sur la couche barrière 13 ;
- former les première et deuxième électrodes 15-16, par gravure de la couche de passivation 14 et d'une partie de l'hétérojonction 20 puis dépôt d'un ou plusieurs matériaux métalliques ;
- former la première plaque de champ 18a et (le cas échéant) la deuxième plaque de champ 18b, par gravure de la couche de passivation 14 puis dépôt d'un ou plusieurs matériaux métalliques, de telle façon que la région flottante 19 soit située à l'aplomb d'un flanc de la première plaque de champ 18a.

Les première et deuxième électrodes 15-16 et les première et deuxième plaques de champ 18a-18b sont de préférence formées simultanément.

Plusieurs techniques peuvent être mises en œuvre pour former la région flottante dopée p 19 dans la couche barrière 13.

La région flottante 19 peut notamment être formée par implantation d'impuretés dopantes de type p (telles que des ions magnésium) dans une portion de la couche barrière 13, de préférence à travers une fine couche de passivation (épaisseur comprise entre 3 nm et 20 nm pour éviter la canalisation des ions implantés) disposée sur la couche barrière 13 et l'ouverture d'un masque disposé sur cette couche de passivation.

La couche barrière 13 et la région flottante 19 peuvent être également formées en faisant croître successivement sur la couche de canal 12 une première sous-couche de matériau semi-conducteur non intentionnellement dopé (ex. UID AlGaN) et une deuxième sous-couche de matériau semi-conducteur dopé p (ex. AlGaN), puis en implantant dans des régions de la deuxième sous-couche (disposées de part et d'autre de la région flottante 19 à former) des impuretés dopantes de type n pour compenser le dopage p ou des ions hydrogène pour neutraliser les impuretés dopantes de type p.

Alternativement, les mêmes régions de la deuxième sous-couche en matériau semi-conducteur dopé p peuvent être gravées à travers des ouvertures d'un masque, après gravure de la fine couche de passivation, pour délimiter la région flottante 19, puis la couche barrière 13 est finalisée (c.-à-d. complétée) en faisant croître par épitaxie du matériau semi-conducteur non intentionnellement dopé en dehors de la région flottante 19. La fine couche de passivation empêche la croissance du matériau semi-conducteur non intentionnellement dopé au-dessus de la région flottante 19.

Enfin, une dernière technique de formation de la région flottante 19 comprend la gravure d'une portion de la couche barrière 13 à travers l'ouverture d'un masque, après gravure de la fine couche de passivation, puis la croissance par épitaxie du matériau semi-conducteur dopé p dans la zone gravée. La fine couche de passivation empêche la croissance du matériau semi-conducteur dopé p en dehors de la zone gravée.

## Revendications

1. Composant électronique à hétérojonction (1) comprenant :
- un substrat (10) ;
- une hétérojonction (20) comprenant une couche de canal (12) disposée sur le substrat (10) et une couche barrière (13) disposée sur la couche de canal (12) ;
- une couche de passivation (14) disposée sur la couche barrière (13) ;
- une plaque de champ (18a) séparée de la couche barrière (13) par une portion (14a) de la couche de passivation (14) ;
- une région flottante (19) en un matériau semi-conducteur dopé de type p, située à l'aplomb d'un flanc de la plaque de champ (18a) ;
**caractérisé en ce que** la région flottante (19) est située dans la couche barrière (13) et a une épaisseur inférieure à celle de la couche barrière (13).

2. Composant (1) selon la revendication 1, dans lequel la région flottante (19) présente une concentration en impuretés dopantes de type p comprise entre 1.10¹⁸ cm⁻³ et 2.10¹⁹ cm⁻³.

3. Composant (1) selon l'une des revendications 1 et 2, dans lequel la région flottante (19) est centrée par rapport au flanc de la plaque de champ (18a).

4. Composant (1) selon l'une quelconque des revendications 1 à 3, dans lequel la région flottante (19) présente une largeur (L_{FZ}) inférieure à deux fois la largeur (L_{FP}) de la plaque de champ (18a).

5. Composant (1) selon l'une quelconque des revendications 1 à 4, comprenant une pluralité de plaques de champs (18a) et une pluralité de régions flottantes (19) en matériau semi-conducteur dopé de type p, chaque région flottante (19) étant située dans la couche barrière (13) à l'aplomb d'un flanc d'une des plaques de champ (18a).

6. Composant (1) selon l'une quelconque des revendications 1 à 5, comprenant en outre une première électrode (15) et une deuxième électrode (16) séparée de la première électrode (15) par une partie au moins de la couche de passivation (14).

7. Composant (1) selon la revendication 6, dans lequel la plaque de champ (18a) forme une extension de la première électrode (15).

8. Composant (1) selon l'une des revendications 6 et 7, de type diode, dans lequel la première électrode (15) est une anode et la deuxième électrode (16) est une cathode.

9. Composant (1) selon l'une des revendications 6 et 7, de type transistor, dans lequel la première électrode (15) est une électrode de grille et la deuxième électrode est une électrode de drain (16).

10. Composant (1) selon l'une quelconque des revendications 1 à 9, dans lequel la couche barrière (13) est constituée du matériau semi-conducteur non intentionnellement dopé.

11. Composant (1) selon l'une quelconque des revendications 1 à 10, dans lequel la région flottante (19) est en contact direct avec la couche de passivation (14).

## Patentansprüche

1. Elektronische Komponente mit einem Heteroübergang (1), umfassend:
- ein Substrat (10);
- einen Heteroübergang (20) mit einer auf dem Substrat (10) angeordneten Kanalschicht (12) und einer auf der Kanalschicht (12) angeordneten Barriereschicht (13);
- eine Passivierungsschicht (14), die auf der Barriereschicht (13) angeordnet ist;
- eine Feldplatte (18a), die von der Barriereschicht (13) durch einen Abschnitt (14a) der Passivierungsschicht (14) getrennt ist;
- einen schwebenden Bereich (19) aus einem p-dotierten Halbleitermaterial, der im Lot zu einer Flanke der Feldplatte (18a) angeordnet ist;
**dadurch gekennzeichnet, dass** sich der schwebende Bereich (19) in der Barriereschicht (13) befindet und eine geringere Dicke als die Barriereschicht (13) aufweist.

2. Komponente (1) nach Anspruch 1, bei der der schwebende Bereich (19) eine p-dotierte Verunreinigungskonzentration zwischen 1,10¹⁸ cm⁻³ und 2,10¹⁹ cm⁻³ aufweist.

3. Komponente (1) nach einem der Ansprüche 1 und 2, bei der der schwebende Bereich (19) in Bezug auf die Flanke der Feldplatte (18a) zentriert ist.

4. Komponente (1) nach einem der Ansprüche 1 bis 3, bei der der schwebende Bereich (19) eine Breite (L_{FZ}) aufweist, die kleiner ist als das Doppelte der Breite (L_{FP}) der Feldplatte (18a).

5. Komponente (1) nach einem der Ansprüche 1 bis 4, eine Vielzahl von Feldplatten (18a) und eine Vielzahl von schwebenden Bereichen (19) aus p-dotiertem Halbleitermaterial umfassend, wobei sich jeder schwebende Bereich (19) in der Barriereschicht (13) im Lot zu einer Flanke einer der Feldplatten (18a) befindet.

6. Komponente (1) nach einem der Ansprüche 1 bis 5, die außerdem eine erste Elektrode (15) und eine zweite Elektrode (16) umfasst, die von der ersten Elektrode (15) durch mindestens einen Teil der Passivierungsschicht (14) getrennt ist.

7. Komponente (1) nach Anspruch 6, bei der die Feldplatte (18a) eine Verlängerung der ersten Elektrode (15) bildet.

8. Komponente (1) nach einem der Ansprüche 6 und 7, vom Typ einer Diode, bei der die erste Elektrode (15) eine Anode und die zweite Elektrode (16) eine Kathode ist.

9. Komponente (1) nach einem der Ansprüche 6 und 7, vom Transistortyp, bei der die erste Elektrode (15) eine Gate-Elektrode und die zweite Elektrode eine Drain-Elektrode (16) ist.

10. Komponente (1) nach einem der Ansprüche 1 bis 9, bei der die Barriereschicht (13) aus dem unbeabsichtigt dotierten Halbleitermaterial besteht.

11. Komponente (1) nach einem der Ansprüche 1 bis 10, bei der der schwebende Bereich (19) in direktem Kontakt mit der Passivierungsschicht (14) steht.

## Claims

1. Heterojunction electronic component (1) comprising:
- a substrate (10);
- a heterojunction (20) comprising a channel layer (12) arranged on the substrate (10) and a barrier layer (13) arranged on the channel layer (12);
- a passivation layer (14) arranged on the barrier layer (13);
- a field plate (18a) separated from the barrier layer (13) by a portion (14a) of the passivation layer (14);
- a floating region (19) made from a p-doped semiconductor material in vertical alignment with a flank of the field plate (18a);
**characterised in that** the floating region (19) is located in the barrier layer (13) and has a thickness less than that of the barrier layer (13).

2. Component (1) according to claim 1, wherein the floating region (19) has a concentration in p type doping impurities comprised between 1.10¹⁸ cm⁻³ and 2.10¹⁹ cm⁻³.

3. Component (1) according to one of claims 1 and 2, wherein the floating region (19) is centred with respect to the flank of the field plate (18a).

4. Component (1) according to any of claims 1 to 3, wherein the floating region (19) has a width (L_{FZ}) less than twice the width (L_{FP}) of the field plate (18a).

5. Component (1) according to any of claims 1 to 4, comprising a plurality of field plates (18a) and a plurality of floating regions (19) made from a p-doped semiconductor material, each floating region (19) being located in the barrier layer (13) in vertical alignment with a flank of one of the field plates (18a).

6. Component (1) according to any of claims 1 to 5, further comprising a first electrode (15) and a second electrode (16) separated from the first electrode (15) by at least a portion of the passivation layer (14).

7. Component (1) according to claim 6, wherein the field plate (18a) forms an extension of the first electrode (15).

8. Component (1) according to one of claims 6 and 7, of the diode type, wherein the first electrode (15) is an anode and the second electrode (16) is a cathode.

9. Component (1) according to one of claims 6 and 7, of the transistor type, wherein the first electrode (15) is a gate electrode and the second electrode is a drain electrode (16).

10. Component (1) according to any of claims 1 to 9, wherein the barrier layer (13) is comprised of an unintentionally doped semiconductor material.

11. Component (1) according to any of claims 1 to 10, wherein the floating region (19) is in direct contact with the passivation layer (14).
